(19)

Europäisches
Patentamt
European
Patent Office
Office européen
des brevets

(11) **EP 2 169 825 B1**

(12) **EUROPEAN PATENT SPECIFICATION**

(45) Date of publication and mention
of the grant of the patent:
**22.02.2012 Bulletin 2012/08**

(51) Int Cl.:
*H03F 3/60* (2006.01)

(21) Application number: **08290905.2**

(22) Date of filing: **24.09.2008**

(54) **High-efficiency dual-state power amplifier**

Hochleistungs-Dual-Leistungsverstärker

Amplificateur de puissance haute efficacité à double état

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**31.03.2010 Bulletin 2010/13**

(73) Proprietor: **Alcatel Lucent
75007 Paris (FR)**

(72) Inventor: **Grebennikov, Andrei
Casleknock, Dublin 15 (IE)**

(74) Representative: **Narmon, Gisèle Marie Thérèse et
al
Alcatel-Lucent Bell NV
Copernicuslaan 50
2018 Antwerpen (BE)**

(56) References cited:
WO-A-01/63756      US-A- 5 025 225
US-A- 6 097 266      US-A1- 2008 136 554

- YOUNKYU CHUNG ET AL: "Efficiency-enhancing
  technique: LDMOS power amplifier using dual-
  mode operation design approach" MICROWAVE
  SYMPOSIUM DIGEST, 2004 IEEE MTT-S
  INTERNATIONAL FORT WORTH, TX, USA JUNE
  6-11, 2004, PISCATAWAY, NJ, USA,IEEE, vol. 2,
  6 June 2004 (2004-06-06), pages 859-862,
  XP010728255 ISBN: 978-0-7803-8331-9
- CYNTHIA Y HANG ET AL: "A High Efficiency
  Power Amplifier System for CDMA" EUROPEAN
  MICROWAVE CONFERENCE, 2002. 32ND, IEEE,
  PISCATAWAY, NJ, USA, 1 October 2002
  (2002-10-01), pages 1-3, XP031068174

**Description**

The present invention relates to a dual-state power amplifier comprising

- a first amplifier having an inlet connected to a first input of said power amplifier and an outlet coupled to an output of said power amplifier via a first quarter-wavelength transmission line,
- a second amplifier having an inlet connected to a second input of said power amplifier and an outlet coupled to said output via a second quarter-wavelength transmission line,
- a third amplifier having an inlet coupled to a third input of said power amplifier and an outlet coupled to said output via a third quarter-wavelength transmission line,
- a fourth amplifier having an inlet coupled to a fourth input of said power amplifier and an outlet coupled to said output via a fourth quarter-wavelength transmission line,

said first and second transmission line being connected in common to said output via a fifth quarter-wavelength transmission line, whilst said third and fourth transmission lines being connected in common to said output via a sixth quarter-wavelength transmission line.

Such a dual-state power amplifier is already known in the art, e.g. from the article "Power Level-Dependent Dual-Operating Mode LDMOS Power Amplifier for CDMA Wireless Base-Station Applications" by Y. Chung, J. Jeong, Y. Wang, D. Ahn, and T. Itoh, published in the IEEE Transactions on Microwave Theory and Techniques, vol. MTT-53, pp. 739-746, Feb. 2005.00.

Also in the document C.Hang et al," A High Efficiency Power Amplifier System for CDMA", European Microwave Conference, 1st October 2002, such a dual state power amplifier is disclosed.

In most communication systems it is required that the power amplifier could operate with high efficiency and high linearity simultaneously. However, there is a tradeoff between efficiency and linearity with improvement in one coming at the expense of another. Besides, many wireless communications systems, such as Global System for Mobile communications/ Enhanced Data rates for GSM Evolution GSM/EDGE, code-division multiple-access CDMA2000 or wide-band code-division multiple-access W-CDMA, require that the power amplifier could deliver a wide range of output powers. As a result, being designed for the highest power level with maximum available efficiency, the power amplifiers in base stations tend to operate less efficiently at lower power levels consuming a lot of extra dc power.

Therefore, it is a real challenge to design a base station power amplifier having high efficiency and high linearity not only at maximum output power but also at lower power levels typically ranging from -6 dBc and less without using of additional linearization schemes.

The existing solution, disclosed in the above-mentioned article, is based on the possibility to use a combiner design technology for dual-state operation.

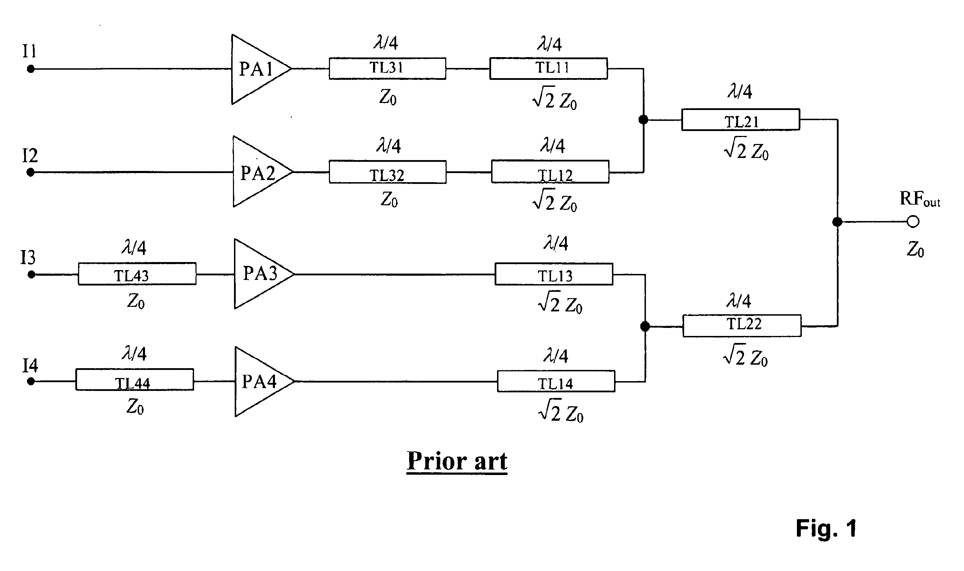

In such a dual-state power amplifier shown in Fig. 1, the power amplifier consisting of a four-amplifier array (PA1-PA4) and a 50-$\Omega$ matched transmission-line combiner (TL11-TL14, TL21-TL22, TL31-TL32, TL43-TL44) operates under two modes depending upon the number of activated power amplifiers.

In a low-state operation, a power amplifier (PA1) is activated only, while all others (PA2-PA4) are switched off. It is assumed that, when power amplifier is switched off, its output impedance is nearly infinite (open circuit) and, due to the effect of the transmission lines with a quarter-wavelength length each, the three deactivated amplifiers are properly isolated from the activated amplifier.

In a high-state operation, all four power amplifiers are evenly delivering maximum power to the 50-$\Omega$ load.

As a result, maximum efficiency is provided at maximum and 6-dB backoff output powers.

However, in reality, at high frequencies the output impedance of a deactivated power amplifier is not an open circuit due to effect of the active device parasitic elements and output matching circuit. Also, additional losses occur due to the asymmetrical structure of the output combiner, and two quarter-wavelength transmission lines are necessary at the input so that the power can be added in phase at the output. As a result, the overall efficiency significantly degrades at both maximum and 6-dB output powers.

An object of the present invention is to provide a dual-state power amplifier of the above known type but which provides high efficiency and high linearity for base station power amplifiers simultaneously at maximum and backoff output power levels.

According to the invention, this object is achieved due to the fact that said power amplifier further comprises a seventh quarter-wavelength transmission line series connected with a first switch between the outlet of said second amplifier and the ground, and a eight quarter-wavelength transmission line series connected with a second switch between the junction point of said third, fourth and sixth transmission lines and the ground.

The proposed architecture of the dual-state power amplifier significantly improves the power amplifier efficiency at maximum and 6-dB backoff power levels by using the two switches connected at the ground ends of the two additional parallel quarter-wavelength transmission lines.

Moreover, since the switches are located between the ground and the ends of the parallel quarter-wavelength transmission lines at the opposite sides of the power combiner, they consume a very small amount of dc power.

There is thus no need in using Digital PreDistortion DPD for performance linearization at backoff powers which is the case for inherently nonlinear Doherty power amplifier.

Other characterizing embodiments of the present invention are that the four inputs of said power amplifier are coupled to outputs of a dual-mode input power divider comprising a plurality of quarter-wavelength transmission line, and that said power amplifier and said dual-mode input power divider form part of a dual-operating mode Laterally Diffused Metal-Oxide Semiconductor LDMOS structure.

Such an amplifier is best suited for code-division multiple-access CDMA or wide-band code-division multiple-access W-CDMA wireless communication base-station applications.

Further characterizing embodiments of the present dual-state power amplifier are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:

Fig. 1 represents a dual-state power amplifier as known from the prior art.
Fig. 2 represents a dual-state power amplifier according to the invention in a first operating state (switches closed);
Fig. 3 represents the dual-state power amplifier according to the invention in a second operating state (switches open); and
Fig. 4 shows characteristics of the present dual-state power amplifier (solid line) with respect to those of a known power amplifier (dashed line).

The present invention relates to a dual-state power amplifier that preferably belongs to an amplifier structure consisting of four parallelly located single-stage LDMOS amplifier array PA1 to PA4, a dual-mode input power divider, and an output power combiner. The dual-operating mode Laterally Diffused Metal-Oxide Semiconductor LDMOS power amplifier is for instance used in code-division multiple-access wireless communication base-station applications.

As mentioned above, a first design of such an amplifier structure is already known in the art and is shown at Fig. 1. The known power amplifier comprises four amplifiers PA1 to PA4 each coupling a distinct input I1 to I4 of the power amplifier to a common output RFout to which a 50 Ω load Zo is connected. It is to be noted that the dual-mode input power divider is not shown at Fig. 1 but that four outputs thereof are connected to the four inputs I1-I4.

In the known power amplifier,

- a first amplifier PA1 has an inlet directly connected to the first input I1 and an outlet coupled to the output RFout via the series connection of a quarter-wavelength $\lambda/4$ transmission line TL31 having a characteristic impedance Zo, a quarter-wavelength $\lambda/4$ transmission line TL11 having a characteristic impedance $\sqrt{2}\,Zo$, and another quarter-wavelength $\lambda/4$ transmission line TL21 having a characteristic impedance $\sqrt{2}\,Zo$;

- a second amplifier PA2 has an inlet directly connected to the second input I2 and an outlet coupled to the output RFout via the series connection of a quarter-wavelength $\lambda/4$ transmission line TL32 having a characteristic impedance Zo, a quarter-wavelength $\lambda/4$ transmission line TL12 having a characteristic impedance $\sqrt{2}\,Zo$, and the transmission line TL21;

- a third amplifier PA3 has an inlet coupled to the third input I3 through a quarter-wavelength $\lambda/4$ transmission line TL43 having a characteristic impedance Zo, and an outlet coupled to the output RFout via the series connection of a quarter-wavelength $\lambda/4$ transmission line TL13 having a characteristic impedance $\sqrt{2}\,Zo$ and a quarter-wavelength $\lambda/4$ transmission line TL22 having a characteristic impedance $\sqrt{2}\,Zo$; and

- a fourth amplifier PA4 has an inlet coupled to the fourth input I4 through a quarter-wavelength $\lambda/4$ transmission line TL44 having a characteristic impedance Zo, and an outlet coupled to the output RFout via the series connection of a quarter-wavelength $\lambda/4$ transmission line TL14 having a characteristic impedance $\sqrt{2}\,Zo$ and the transmission line TL22.

The quarter-wavelength $\lambda/4$ transmission lines TL11-TL14, TL21-TL22 and TL31-TL32 form together a 50 Ω matched transmission-line combiner or output power combiner of the power amplifier that operates under two modes depending upon the number of activated power amplifiers.

In a low-state operation, the power amplifier PA1 is activated only, while all other amplifiers PA2-PA4 are switched off. It is assumed that, when power amplifier is switched off, its output impedance is nearly infinite (open circuit) and, due to the effect of the transmission lines with a quarter-wavelength length each, the three deactivated amplifiers are properly isolated from the activated amplifier.

In a high-state operation, all four power amplifiers PA1-PA4 are evenly delivering maximum power to the 50 Ω load Zo.

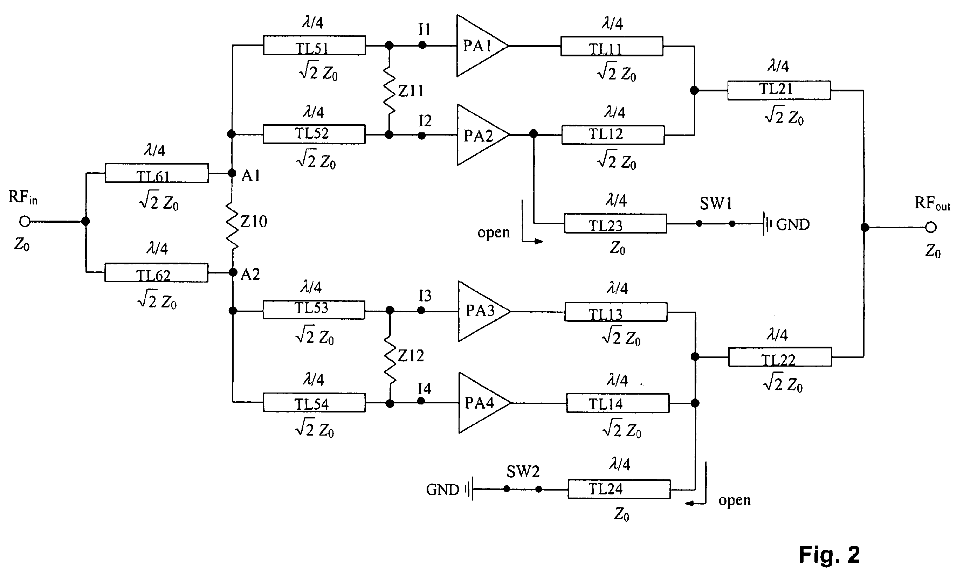

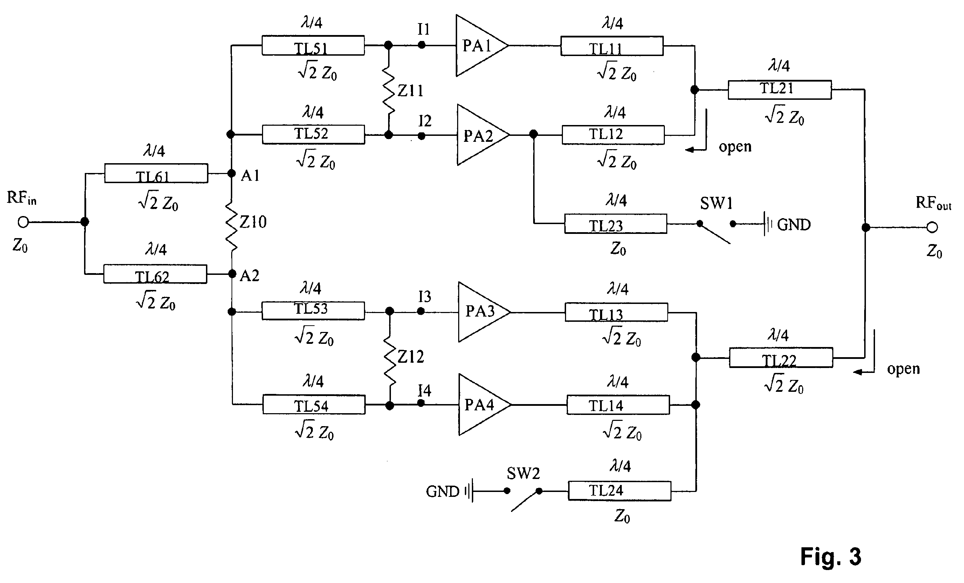

The architecture of the dual-state power amplifier proposed by the present invention is shown at the Figs. 2 and 3. This new architecture significantly improves the power amplifier efficiency at maximum and 6 dB backoff power levels by using two switches SW1 and SW2 connected at the ground ends GND of two additional parallel quarter-wavelength λ/4 transmission line TL23 and TL24 having a characteristic impedance Zo. Additionally, the transmission lines TL31 and TL32 as well as TL43 and TL44 of the known power amplifier are now removed.

The power amplifier of the present invention is shown in the two operation states: at Fig. 2 with the switches SW1 and SW2 closed, and at Fig. 3 with the switches SW1 and SW2 open.

This power amplifier comprises

- a first amplifier PA1 having an inlet directly connected to the first input I1 and an outlet coupled to the output RFout via the series connection of a quarter-wavelength λ/4 transmission line TL11 having a characteristic impedance $\sqrt{2}\,Z_0$ and another quarter-wavelength λ/4 transmission line TL21 having a characteristic impedance $\sqrt{2}\,Z_0$;

- a second amplifier PA2 having an inlet directly connected to the second input I2 and an outlet coupled to the output RFout via the series connection of a quarter-wavelength λ/4 transmission line TL12 having a characteristic impedance $\sqrt{2}\,Z_0$ and the transmission line TL21;

- a third amplifier PA3 having an inlet directly connected to the third input I3 and an outlet coupled to the output RFout via the series connection of a quarter-wavelength λ/4 transmission line TL13 having a characteristic impedance $\sqrt{2}\,Z_0$ and a quarter-wavelength λ/4 transmission line TL22 having a characteristic impedance $\sqrt{2}\,Z_0$; and

- a fourth amplifier PA4 having an inlet coupled to the fourth input I4 and an outlet coupled to the output RFout via the series connection of a quarter-wavelength λ/4 transmission line TL14 having a characteristic impedance $\sqrt{2}\,Z_0$ and the transmission line TL22.

The power amplifier further comprises a quarter-wavelength λ/4 transmission line TL23 having a characteristic impedance Zo and being series connected with a first switch SW1 between the outlet of the second amplifier PA2 and the ground GND, as well as another quarter-wavelength λ/4 transmission line TL24 having a characteristic impedance Zo and being series connected with a second switch SW2 between the junction point of the transmission lines TL13, TL14 and TL22 with the ground GND.

The quarter-wavelength λ/4 transmission lines TL11-TL14 and TL21-TL24 form together a 50 Ω matched transmission-line combiner or output power combiner of the power amplifier that operates under two modes depending upon the number of activated power amplifiers.

As already mentioned, the power amplifier is associated to a dual-mode input power divider coupling a general input RFin to the four inputs I1-I4.

The input power divider comprises

- the series connection of a quarter-wavelength λ/4 transmission line TL61 having a characteristic impedance $\sqrt{2}\,Z_0$ with another quarter-wavelength λ/4 transmission line TL51 having a characteristic impedance $\sqrt{2}\,Z_0$ between the inputs RFin and I1;

- the series connection of the transmission line TL61 with a quarter-wavelength λ/4 transmission line TL52 having a characteristic impedance $\sqrt{2}\,Z_0$ between the inputs RFin and I2;

- the series connection of a quarter-wavelength λ/4 transmission line TL62 having a characteristic impedance $\sqrt{2}\,Z_0$ with a quarter-wavelength λ/4 transmission line TL53 having a characteristic impedance $\sqrt{2}\,Z_0$ between the inputs RFin and I3; and

- the series connection of the transmission line TL62 with a quarter-wavelength λ/4 transmission line TL54 having a characteristic impedance $\sqrt{2}\,Z_0$ between the inputs RFin and I4.

An impedance Z10 is further provided between a terminal A1 that is a junction point between the transmission lines TL61, TL51 and TL52, and a terminal A2 that is a junction point between the transmission lines TL62, TL53 and TL54.

An impedance Z11 is also provided between the inputs I1 and I2, whilst another impedance Z12 is provided between the inputs I3 and I4.

Both the power amplifier and the dual-mode input power divider form part of a dual-operating mode laterally diffused metal-oxide semiconductor LDMOS power amplifier.

As shown at Fig. 2, in a high-power mode when all four power amplifiers PA1-PA4 are activated, the switches SW1 and SW2 are turned on providing an open circuit conditions at the opposite input ends of these transmission lines TL23 and TL24, and all four power amplifiers PA1-PA4 are evenly delivering maximum power to the 50 Ω load. In this case, the power combining structure is symmetrical and each power amplifying path contains only two series quarter-wavelength transmission lines resulting in smaller losses compared to the above known combiner.

In a low-state mode when the power amplifier PA1 is activated only, as shown at Fig. 3, the switches SW1 and SW2 are turned off providing a short circuit conditions at the input ends of these quarter-wavelength transmission lines, resulting in a complete isolation of the deactivated power amplifiers PA2-PA4 from the activated one PA1.

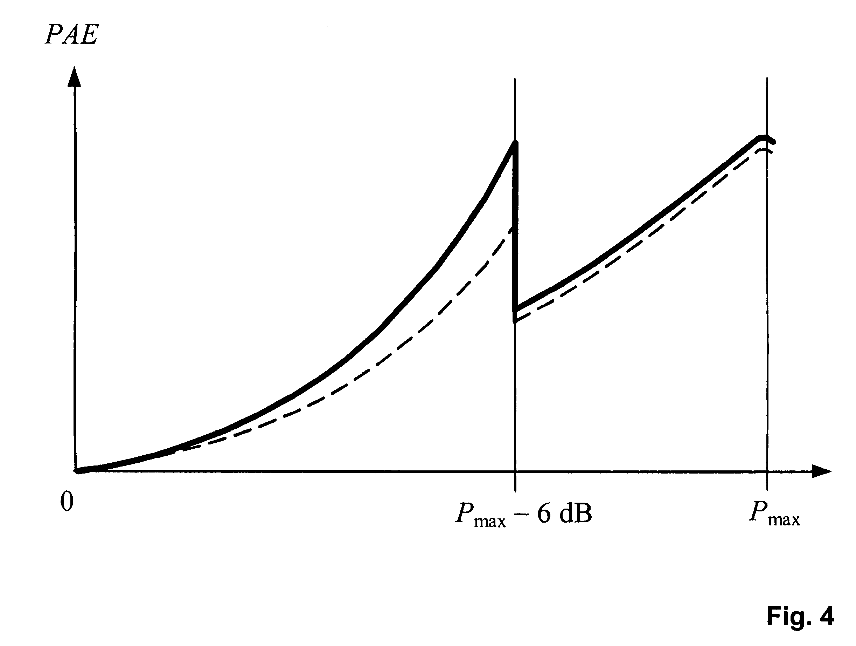

Consequently, the two peak high efficiencies can be achieved at maximum and 6 dB backoff power levels, as shown in Fig. 4 (dashed line corresponds to the above known power amplifier represented at Fig. 1), and these efficiencies will be significantly higher than that of for this known dual-state power amplifier.

Moreover, since the switches are located between the ground and the ends of the parallel quarter-wavelength transmission lines at the opposite sides of the power combiner, they consume a very small amount of dc power.

It is to be noted that a bias control unit generally is necessary to turn on or off the transistors and the switches.

It is also to be noted that the number of stages in all power amplifier stages may be different depending on the required output power and power gain, and the input and output impedances of each power amplifier are equal to Zo.

It is finally to be noted that any type of switches can be used including the MEMS or pin-diode switches.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A dual-state power amplifier comprising
a first amplifier (PA1) having an inlet connected to a first input (I1) of said power amplifier and an outlet coupled to an output (RFout) of said power amplifier via a first quarter-wavelength transmission line (TL11),
a second amplifier (PA2) having an inlet connected to a second input (I2) of said power amplifier and an outlet coupled to said output (RFout) via a second quarter-wavelength transmission line (TL12),
a third amplifier (PA3) having an inlet coupled to a third input (I3) of said power amplifier and an outlet coupled to said output (RFout) via a third quarter-wavelength transmission line (TL13),
a fourth amplifier (PA4) having an inlet coupled to a fourth input (I4) of said power amplifier and an outlet coupled to said output (RFout) via a fourth quarter-wavelength transmission line (TL14),
said first (TL11) and second (TL12) transmission line being connected in common to said output (RFout) via a fifth quarter-wavelength transmission line (TL21), whilst said third (TL13) and fourth (TL14) transmission lines being connected in common to said output (RFout) via a sixth quarter-wavelength transmission line (TL22),
**characterized in that** said power amplifier further comprises a seventh quarter-wavelength transmission line (TL23) series connected with a first switch (SW1) between the outlet of said second amplifier (PA2) and the ground (GND),
and an eight quarter-wavelength transmission line (TL24) series connected with a second switch (SW2) between the junction point of said third (TL13), fourth (TL14) and sixth (TL22) transmission lines and the ground (GND).

2. The power amplifier according to claim 1, **characterized in that** said power amplifier is adapted to operate either with only said first amplifier (PA1) or with all said four amplifiers (PA1-PA4).

3. The power amplifier according to claim 1, **characterized in that** said four inputs (I1-I4) of said power amplifier are coupled to outputs of a dual-mode input power divider comprising a plurality of quarter-wavelength transmission line (TL51-TL54, TL61, TL62).

4. The power amplifier according to claim 3, **characterized in that** said power amplifier and said dual-mode input power divider form part of a dual-operating mode laterally diffused metal-oxide semiconductor LDMOS structure.

**5.** The power amplifier according to claim 1, ***characterized in that*** said first (SW1) and second (SW2) switches are designed according to the MEMS technology.

**6.** The power amplifier according to claim 1, ***characterized in that*** said first (SW1) and second (SW2) switches are pin-diode switches.

**7.** The power amplifier according to claim 1, ***characterized in that*** said output (RFout) is connected to a 50 S2 load ($Z_0$).


**Patentansprüche**

**1.** Dual-Leistungsverstärker, umfassend:

Einen ersten Verstärker (PA1) mit einem Einlass, der an einen ersten Eingang (I1) des besagten Leistungsverstärkers angeschlossen ist, und einem Auslass, der über eine erste Viertelwellenlängen-Übertragungsleitung (TL11) an einen Ausgang (RFout) des besagten Leistungsverstärkers gekoppelt ist,
einen zweiten Verstärker (PA2) mit einem Einlass, der an einen zweiten Eingang (I2) des besagten Leistungsverstärkers angeschlossen ist, und einem Auslass, der über eine zweite Viertelwellenlängen-Übertragungsleitung (TL12) an den besagten Ausgang (RFout) gekoppelt ist,
einen dritten Verstärker (PA3) mit einem Einlass, der an einen dritten Eingang (I3) des besagten Leistungsverstärkers gekoppelt ist, und einem Auslass, der über eine dritte Viertelwellenlängen-Übertragungsleitung (TL13) an den besagten Ausgang (RFout) gekoppelt ist,
einen vierten Verstärker (PA4) mit einem Einlass, der an einen vierten Eingang (I4) des besagten Leistungsverstärkers gekoppelt ist, und einem Auslass, der über eine vierte Viertelwellenlängen-Übertragungsleitung (TL14) an den besagten Ausgang (RFout) gekoppelt ist,
wobei die besagte erste (TL11) und die besagte zweite (TL12) Übertragungsleitung gemeinsam über eine fünfte Viertelwellenlängen-Übertragungsleitung (TL21) an den besagten Ausgang (RFout) angeschlossen sind, während die besagte dritte (TL13) und die besagte vierte (TL14) Übertragungsleitung gemeinsam über eine sechste Viertelwellenlängen-Übertragungsleitung (TL22) an den besagten Ausgang (RFout) angeschlossen sind,
***dadurch gekennzeichnet, dass*** der besagte Leistungsverstärker weiterhin eine siebte Viertelwellenlängen- Übertragungsleitungsserie (TL23), welche mit einem ersten Schalter (SW1) zwischen dem Auslass des besagten zweiten Verstärkers (PA2) und der Erde (GND) angeschlossen ist,
und eine achte Viertelwellenlängen-Übertragungsleitungsserie (TL24), welche mit einem zweiten Schalter (SW2) zwischen dem Knotenpunkt der besagten dritten (TL13), der besagten vierten (TL14) und der besagten sechsten (TL22) Übertragungsleitung und der Erde (GND) angeschlossen ist,

umfasst.

**2.** Leistungsverstärker nach Anspruch 1, ***dadurch gekennzeichnet, dass*** der besagte Leistungsverstärker dazu ausgelegt ist, entweder nur mit dem besagten ersten Verstärker (PA1) oder mit allen besagten vier Verstärkern (PA1-PA4) zu arbeiten.

**3.** Leistungsverstärker nach Anspruch 1, ***dadurch gekennzeichnet, dass*** die besagten vier Eingänge (I1-I4) des besagten Leistungsverstärkers an Ausgänge eines Dual-Modus-Eingangsleistungsteilers mit einer Mehrzahl von Viertelwellenlängen-Übertragungsleitungen (TL51-TL54, TL61, TL62) gekoppelt sind.

**4.** Leistungsverstärker nach Anspruch 3, ***dadurch gekennzeichnet, dass*** der besagte Leistungsverstärker und der besagte Dual-Modus-Eingangsleistungsteiler Teil einer im Dual-Betriebsmodus arbeitenden lateral diffundierten Metall-Oxid-Halbleiter, LDMOS-Struktur bilden.

**5.** Leistungsverstärker nach Anspruch 1, ***dadurch gekennzeichnet, dass*** der besagte erste (SW1) und der besagte zweite (SW2) Schalter gemäß der MEMS-Technologie ausgelegt sind.

**6.** Leistungsverstärker nach Anspruch 1, ***dadurch gekennzeichnet, dass*** der besagte erste (SW1) und der besagte zweite (SW2) Schalter PIN-Dioden-Schalter sind.

**7.** Leistungsverstärker nach Anspruch 1, ***dadurch gekennzeichnet, dass*** der besagte Ausgang (RFout) an eine 50 -Last ($Z_o$) angeschlossen ist.


**Revendications**

**1.** Amplificateur de puissance à double état comprenant
un premier amplificateur (PA1) comportant un orifice d'entrée connecté à une première entrée (I1) dudit amplificateur de puissance et un orifice de sortie couplé à une sortie (RFout) dudit amplificateur de puissance par l'intermédiaire d'une première ligne de transmission en quart d'onde (TL11),

un deuxième amplificateur (PA2) comportant un orifice d'entrée connecté à une deuxième entrée (I2) dudit amplificateur de puissance et un orifice de sortie couplé à ladite sortie (RFout) par l'intermédiaire d'une deuxième ligne de transmission en quart d'onde (TL12),

un troisième amplificateur (PA3) comportant un orifice d'entrée couplé à une troisième entrée (I3) dudit amplificateur de puissance et un orifice de sortie couplé à ladite sortie (RFout) par l'intermédiaire d'une troisième ligne de transmission en quart d'onde (TL13),

un quatrième amplificateur (PA4) comportant un orifice d'entrée couplé à une quatrième entrée (I4) dudit amplificateur de puissance et un orifice de sortie couplé à ladite sortie (RFout) par l'intermédiaire d'une quatrième ligne de transmission en quart d'onde (TL14),

lesdites première (TL11) et deuxième (TL12) lignes de transmission étant connectées en commun à ladite sortie (RFout) par l'intermédiaire d'une cinquième ligne de transmission en quart d'onde (TL21), alors que lesdites troisième (TL13) et quatrième (TL14) lignes de transmission sont connectées en commun à ladite sortie (RFout) par l'intermédiaire d'une sixième ligne de transmission en quart d'onde (TL22),

*caractérisé en ce que* ledit amplificateur de puissance comprend en outre une septième ligne de transmission en quart d'onde (TL23) connectée en série à un premier commutateur (SW1) entre l'orifice de sortie dudit deuxième amplificateur (PA2) et la terre (GND),

et une huitième ligne de transmission en quart d'onde (TL24) connectée en série à un deuxième commutateur (SW2) entre le point de jonction desdites troisième (TL13), quatrième (TL14) et sixième (TL22) lignes de transmission et la terre (GND).

2. Amplificateur de puissance selon la revendication 1, *caractérisé en ce que* ledit amplificateur de puissance est adapté pour fonctionner avec seulement ledit premier amplificateur (PA1) ou avec tous lesdits quatre amplificateurs (PA1 à PA4).

3. Amplificateur de puissance selon la revendication 1, *caractérisé en ce que* lesdites quatre entrées (I1 à I4) dudit amplificateur de puissance sont couplées aux sorties d'un diviseur de puissance d'entrée à double mode comprenant une pluralité de lignes de transmission en quart d'onde (TL51 à TL54, TL61, TL62).

4. Amplificateur de puissance selon la revendication 3, *caractérisé en ce que* ledit amplificateur de puissance et ledit diviseur de puissance d'entrée à double mode font partie d'une structure LDMOS (métal-oxyde-semiconducteur à diffusion latérale) à double mode de fonctionnement.

5. Amplificateur de puissance selon la revendication 1, *caractérisé en ce que* lesdits premier (SW1) et deuxième (SW2) commutateurs sont conçus conformément à la technologie MEMS.

6. Amplificateur de puissance selon la revendication 1, *caractérisé en ce que* lesdits premier (SW1) et deuxième (SW2) commutateurs sont des commutateurs à diode PIN.

7. Amplificateur de puissance selon la revendication 1, *caractérisé en ce que* ladite sortie (RFout) est connectée à une charge de 50 $\Omega$ ($Z_0$).

**Prior art**

**Fig. 1**

EP 2 169 825 B1

Fig. 2

EP 2 169 825 B1

RF$_{out}$ $Z_0$

open

$\lambda/4$ TL21 $\sqrt{2}Z_0$

$\lambda/4$ TL22 $\sqrt{2}Z_0$

open

SW1 $\parallel$ GND

$\lambda/4$ TL11 $\sqrt{2}Z_0$  $\lambda/4$ TL12 $\sqrt{2}Z_0$  $\lambda/4$ TL23 $Z_0$

$\lambda/4$ TL13 $\sqrt{2}Z_0$  $\lambda/4$ TL14 $\sqrt{2}Z_0$  $\lambda/4$ TL24 $Z_0$

SW2 GND $\parallel$

PA1  PA2  PA3  PA4

I1  I2  I3  I4

Z11  Z12

$\lambda/4$ TL51 $\sqrt{2}Z_0$  $\lambda/4$ TL52 $\sqrt{2}Z_0$  $\lambda/4$ TL53 $\sqrt{2}Z_0$  $\lambda/4$ TL54 $\sqrt{2}Z_0$

A1  Z10  A2

$\lambda/4$ TL61 $\sqrt{2}Z_0$  $\lambda/4$ TL62 $\sqrt{2}Z_0$

RF$_{in}$ $Z_0$

Fig. 3

10

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Y. Chung ; J. Jeong ; Y. Wang ; D. Ahn ; T. Itoh.** Power Level-Dependent Dual-Operating Mode LDMOS Power Amplifier for CDMA Wireless Base-Station Applications. *IEEE Transactions on Microwave Theory and Techniques,* February 2005, vol. MTT-53, 739-746

- **C.Hang et al.** A High Efficiency Power Amplifier System for CDMA. *European Microwave Conference,* 01 October 2002